Europäisches Patentamt

European Patent Office

Office européen des brevets

(11) Publication number: **0 356 885**
**A2**

## EUROPEAN PATENT APPLICATION

(21) Application number: 89115479.1

(51) Int. Cl.⁵: **H03G 5/10 , H03G 9/18**

(22) Date of filing: 22.08.89

(30) Priority: 23.08.88 US 235306

(43) Date of publication of application:
**07.03.90 Bulletin 90/10**

(84) Designated Contracting States:
**ES GR**

(71) Applicant: **B.W.N. WAVEPUR RIGHTS COMPANY**
**50 South San Gabriel Boulevard**
**Pasadena California 91107(US)**

(72) Inventor: **Sabatini, Michael Glen**
**18217 Donmetz Street**
**Northridge California 91107(US)**

(74) Representative: **Baillie, Iain Cameron et al**
**c/o Ladas & Parry Isartorplatz 5**
**D-8000 München 2(DE)**

(54) Frequency-compensated linear sliding band network.

(57) Presented herein is a circuit for sound improvement having a Vin and a Vout as well as power and ground connection. The circuit is used in combination with a Dolby-type expander limiter negating the necessity of a compressor or decoder. It is comprised of a prefilter connected at one end to Vin, a buffer having an input and an output the input being connected to the prefilter. The Dolby-type expander which has an input and an output is connected to the present invention such that the output of the buffer is connected to the input of the limiter as well as to Vout, the output of the limiter being connected between the prefilter and the buffer.

FIG. 1

## FREQUENCY COMPENSATED LINEAR SLIDING-BAND NETWORK

### BACKGROUND OF THE INVENTION

Dynamic filtering and noise reduction have been known for years. These systems are fairly complex and mask background noise which would otherwise be introduced by the use of a particular recording media or transmission technique present in audio signals. The present invention makes use of a modified Dolby-type expander. Instead of combining this expander with a compressor and decoder, it combines it with a simple, tunable signal conditioning system to create a clean and appealing output signal. The present invention therefore obviates the need of a compressor and decoder presenting instead a simplified, tunable system for sound enhancement.

### SUMMARY OF THE INVENTION

The present invention uses a modified Dolby-type expander and couples it to a tunable signal conditioner. Overall the circuit combines the noise suppression characteristics of a Dolby-type expander with carefully tuned pre and post emphasis filters. Together these result in a flat frequency response having substantial noise reduction with no decoding required.

### BRIEF DESCRIPTION OF THE DRAWINGS

Figure 1 is a block diagram of a signal processing system making use of the invention.
Figure 2 is a schematic diagram of an embodiment of the present invention corresponding to the block diagram of figure 1.
Figure 3 is an equivalent circuit of section (4A) of the signal conditioner circuit.
Figure 4 is an equivalent circuit of the signal conditioning circuit and buffer.
Figure 4-1 through 4-3 are gain charts for figure 4.
Figure 5 is an equivalent circuit of a first portion of the limiter circuit.
Figures 5-1 through 5-8 are gain charts for figure 5.

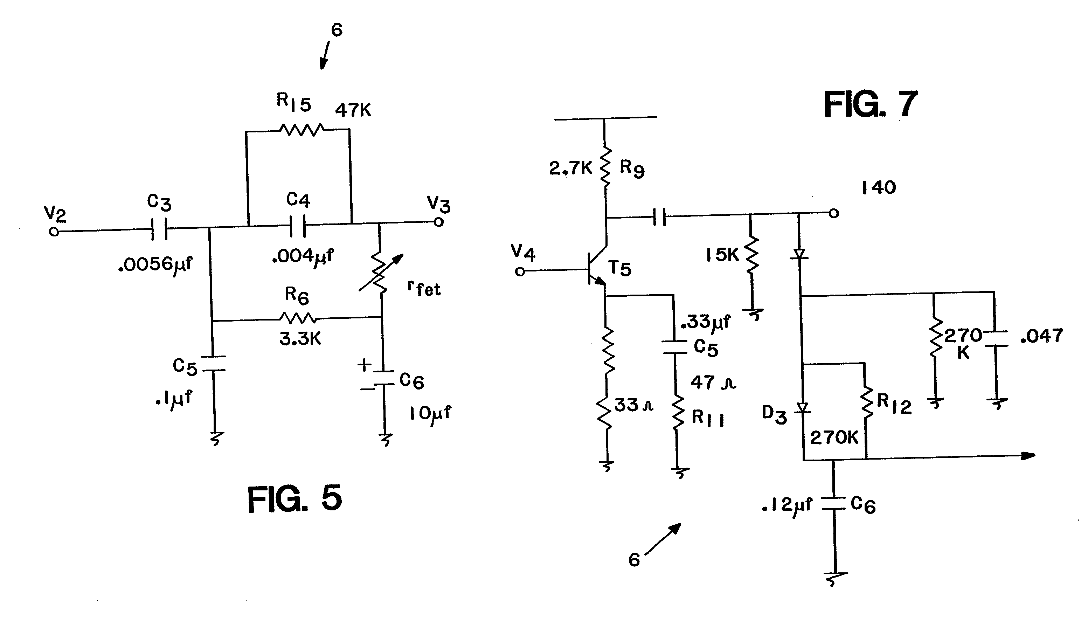

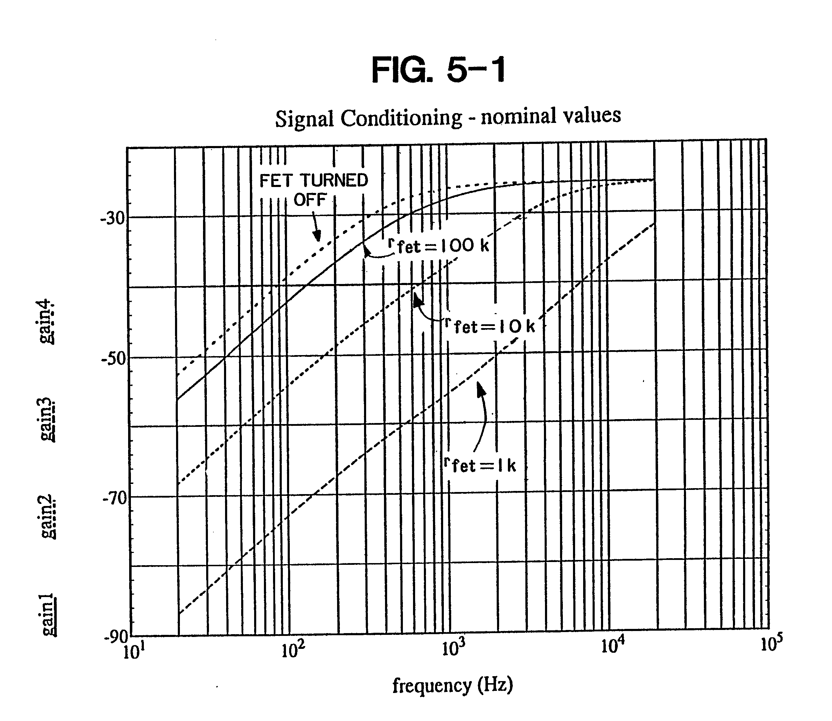

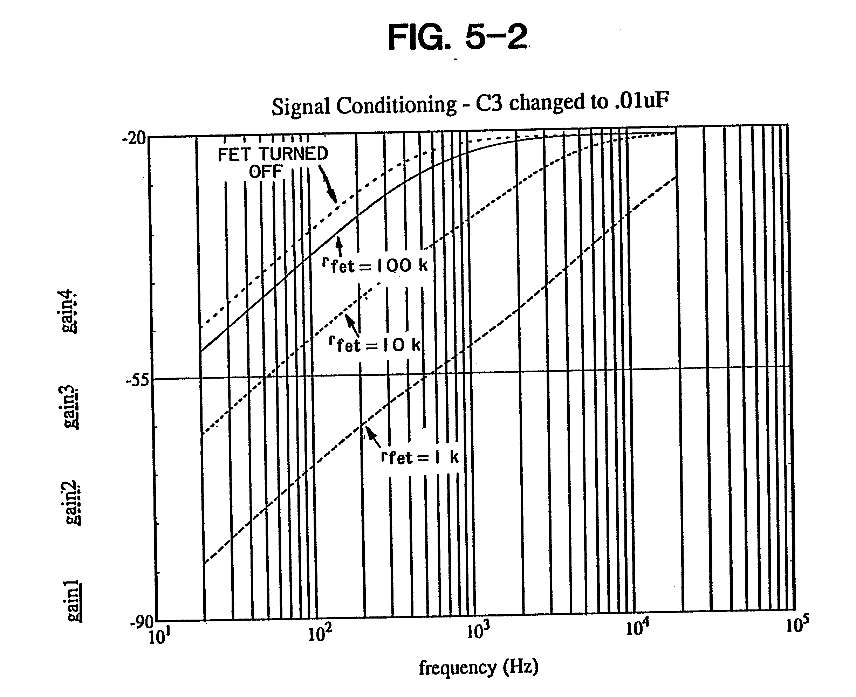

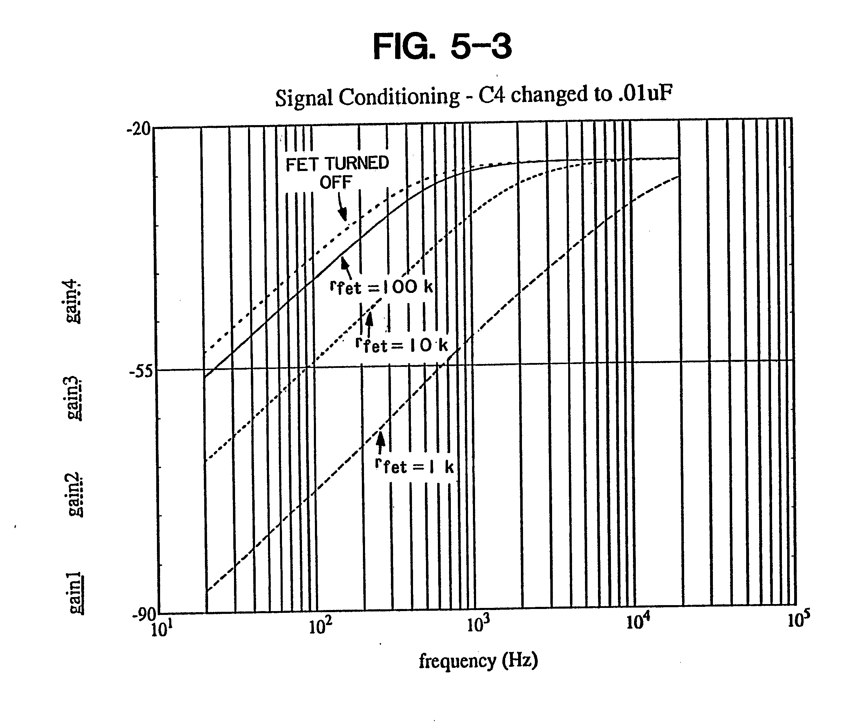

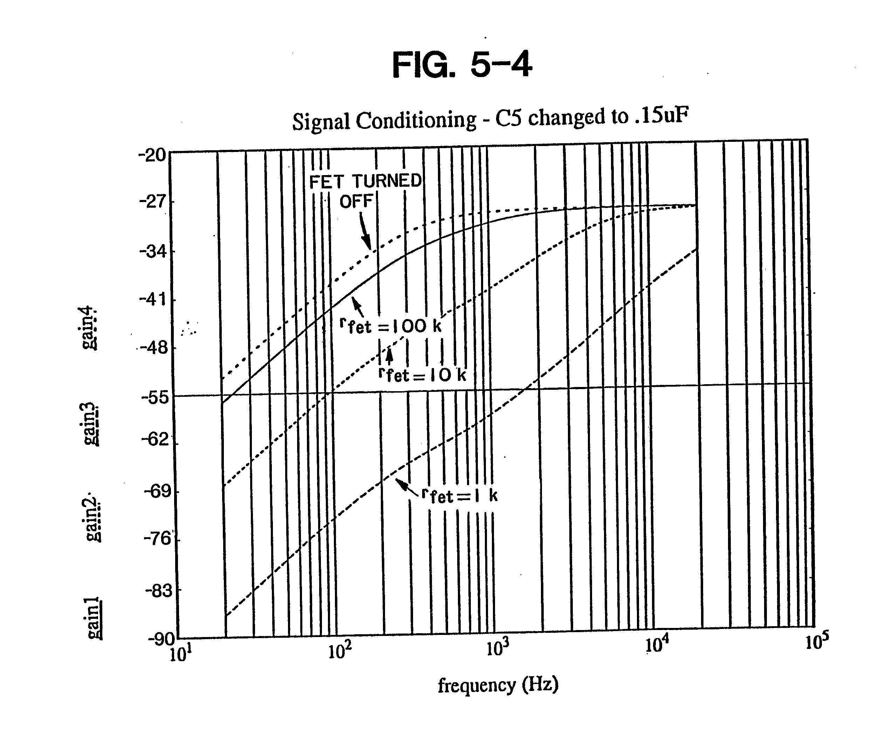

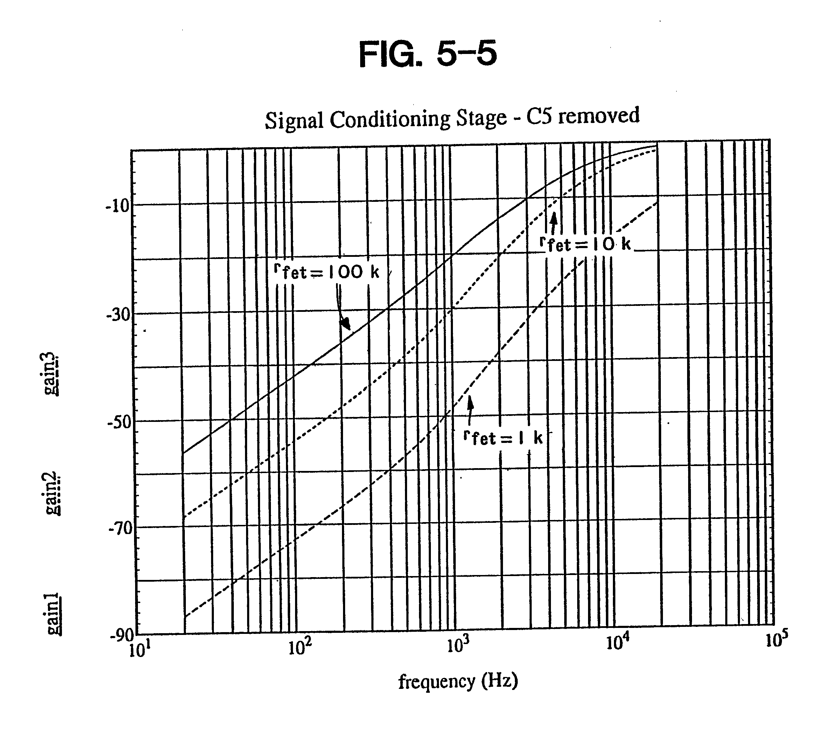

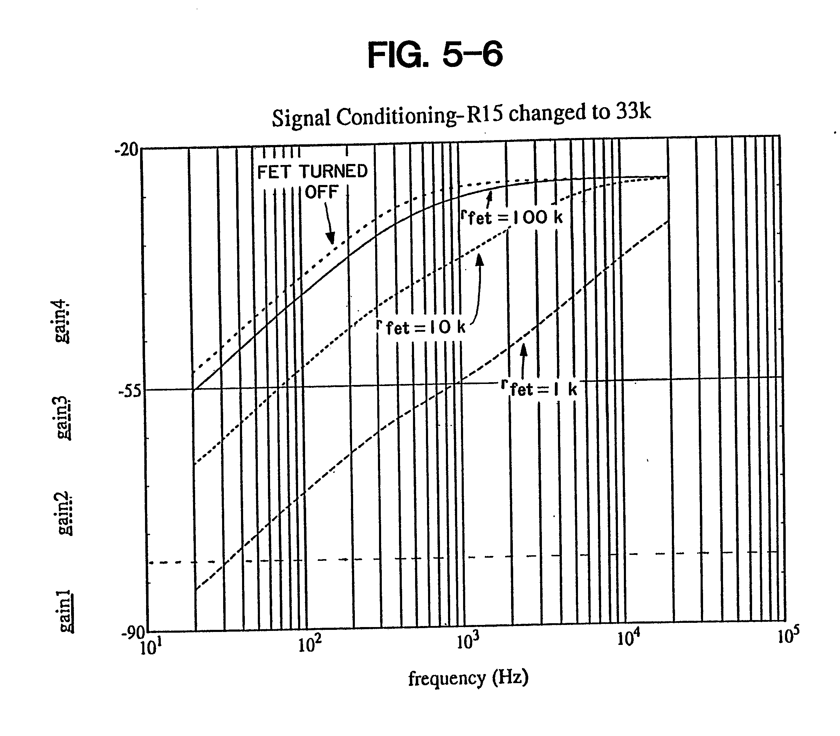

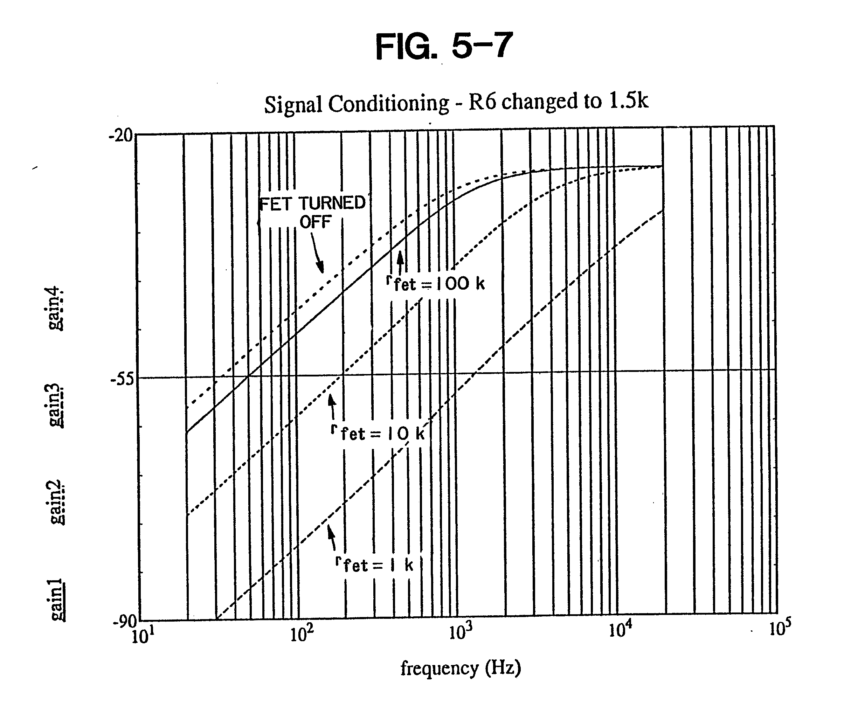

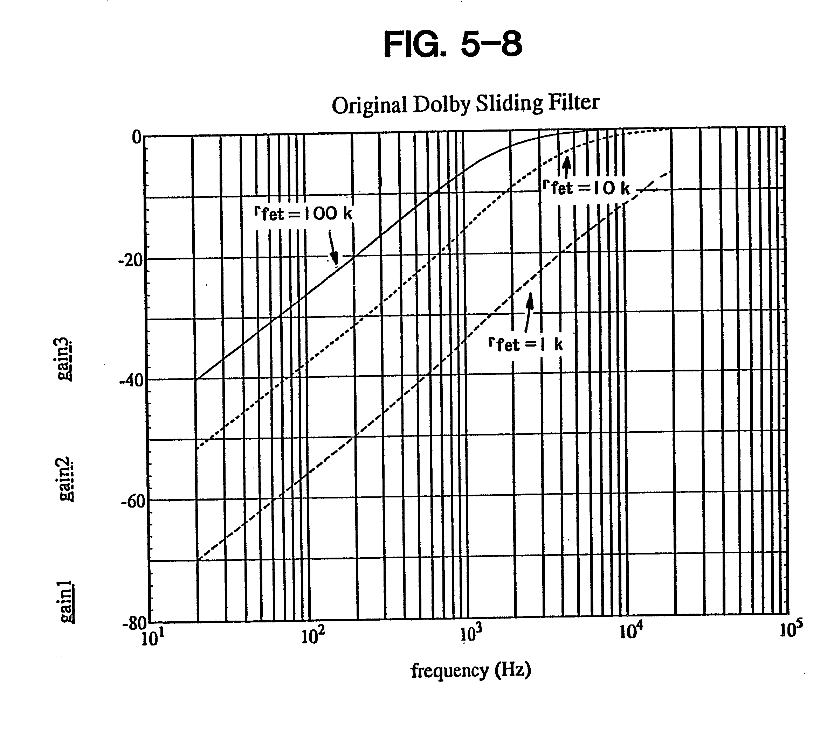

Figure 5-9 is a gain chart for the original Dolby sliding filter.

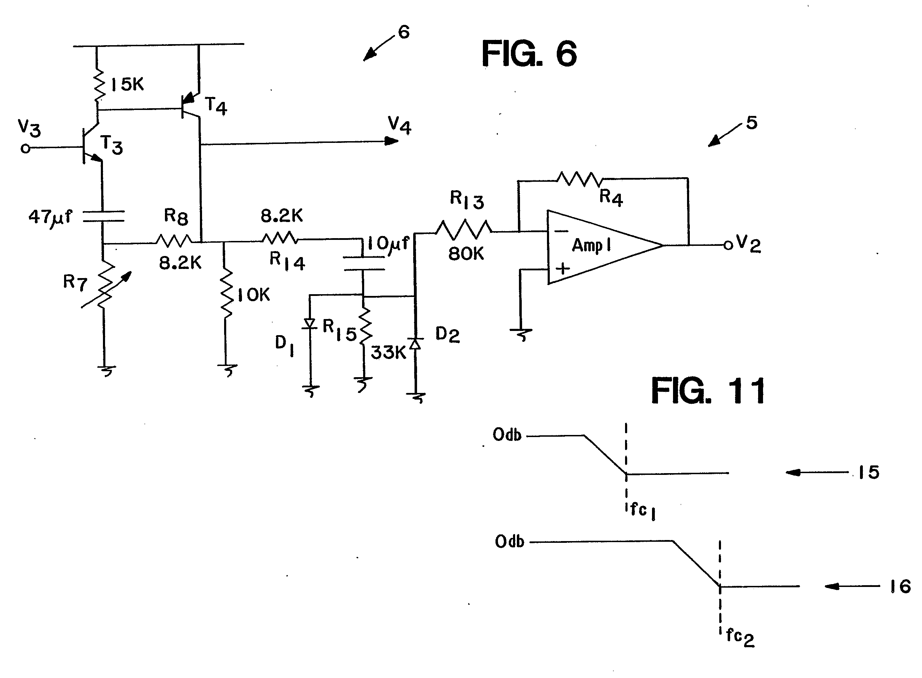

Figure 6 is an equivalent circuit of a second portion of the limiter and the buffer.

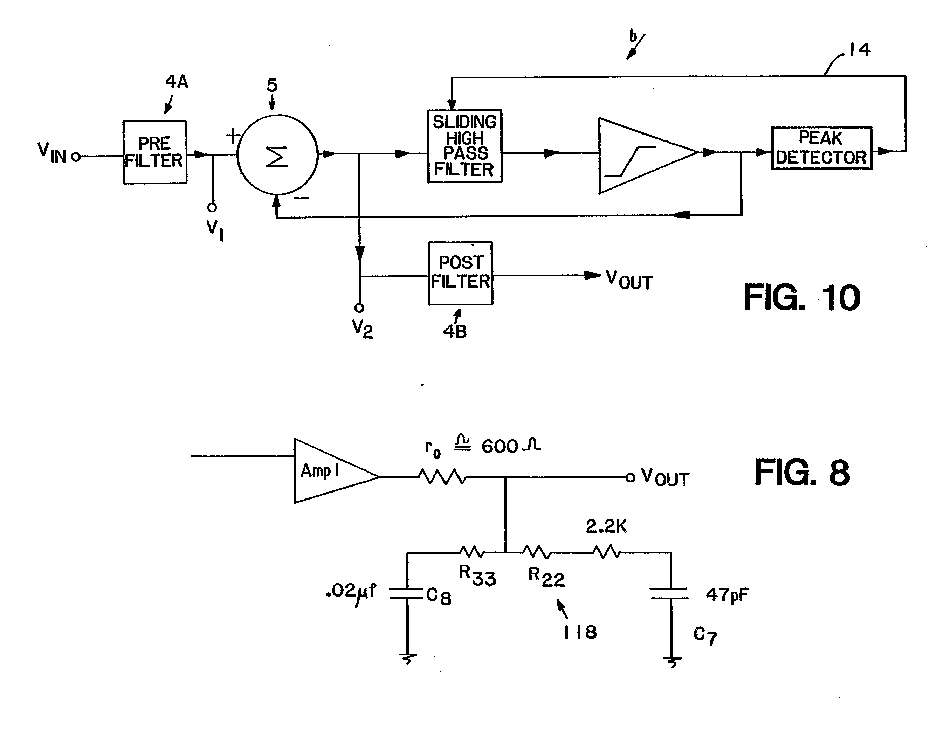

Figure 7 is an equivalent circuit of a last portion of the limiter circuit.

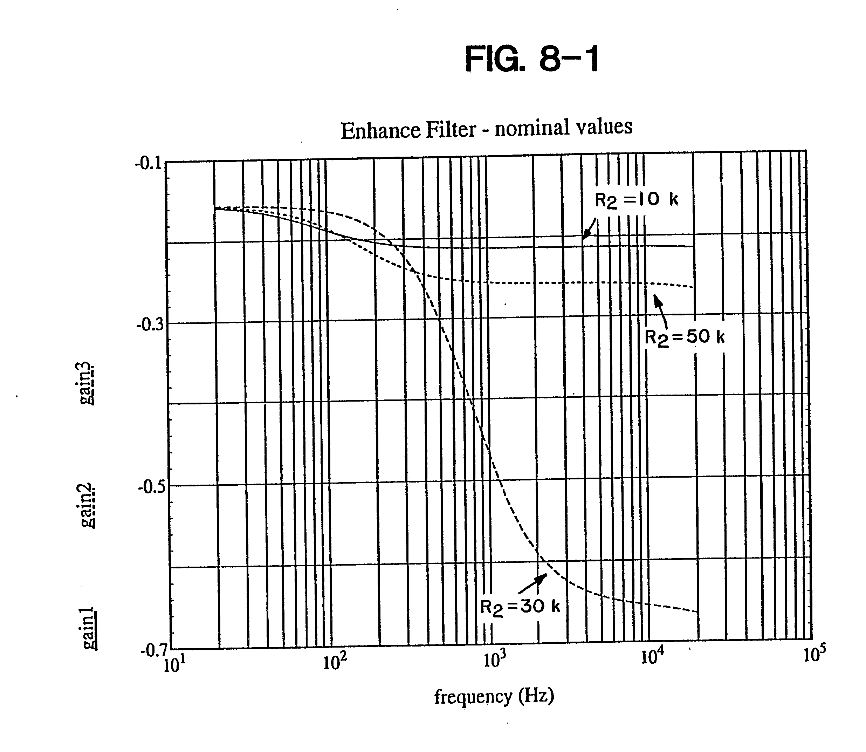

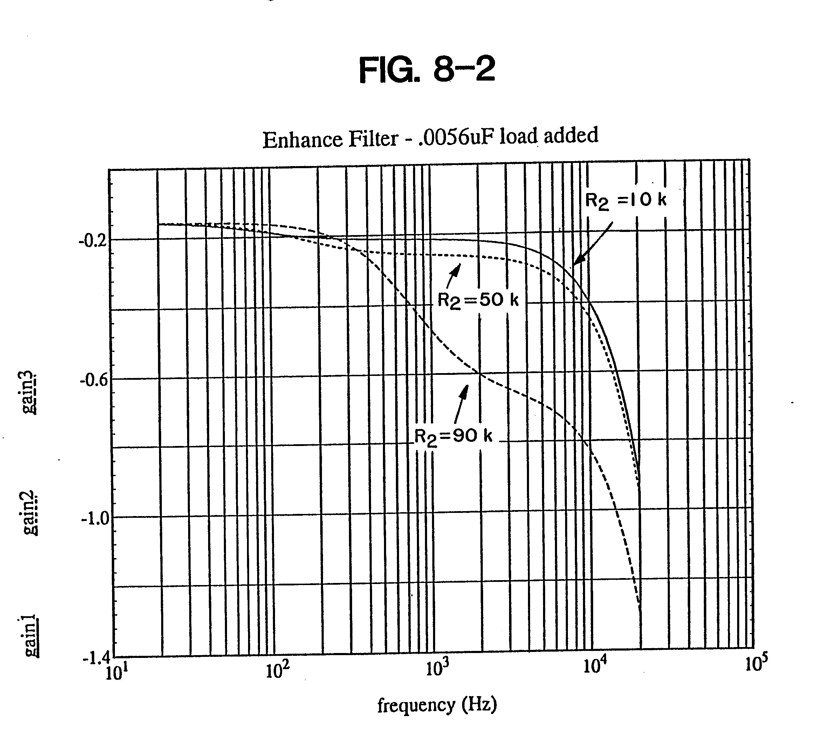

Figure 8 is an equivalent circuit of the post filter.
Figures 8-1 and 8-2 are gain charts for figure 8.

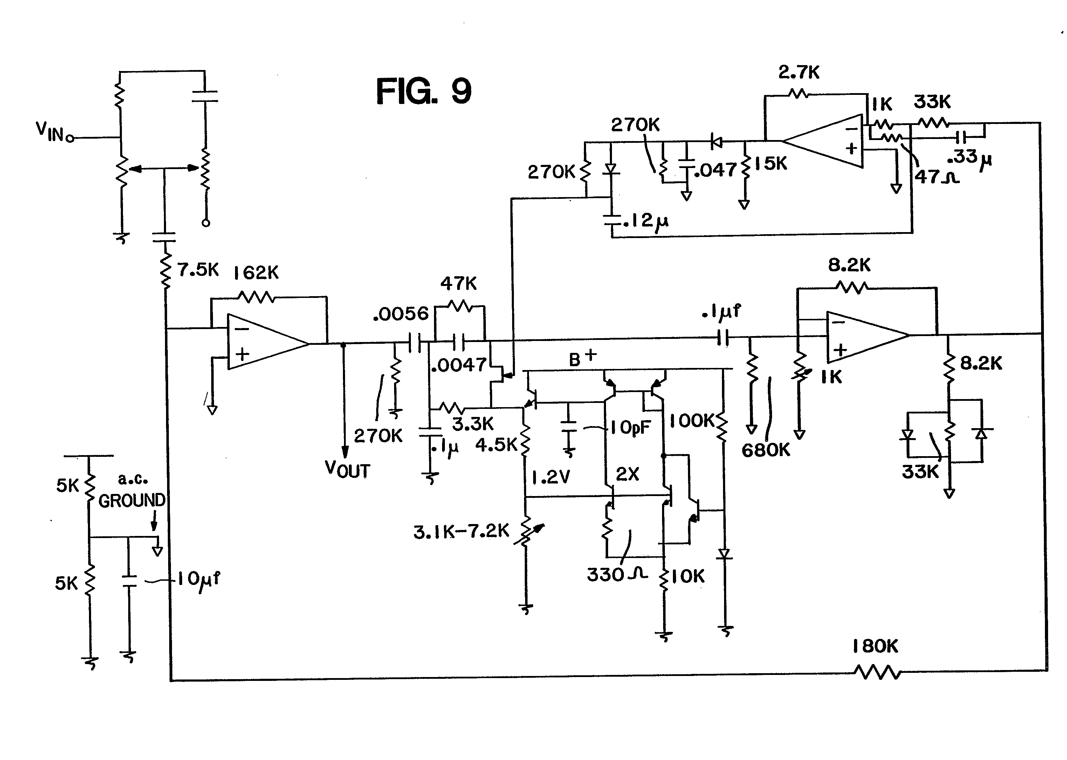

Figure 9 shows a slightly modified version of the present invention.
Figure 10 is a second block diagram of the present invention.
Figure 11 is a corner frequency analysis.

### DETAILED DESCRIPTION OF THE DRAWINGS

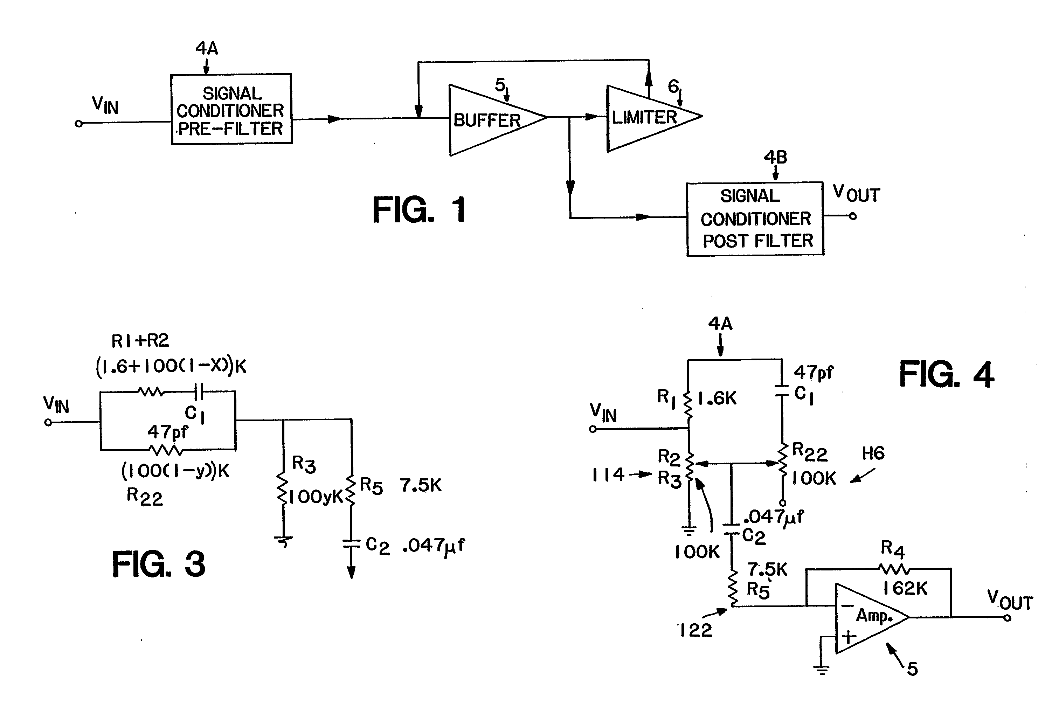

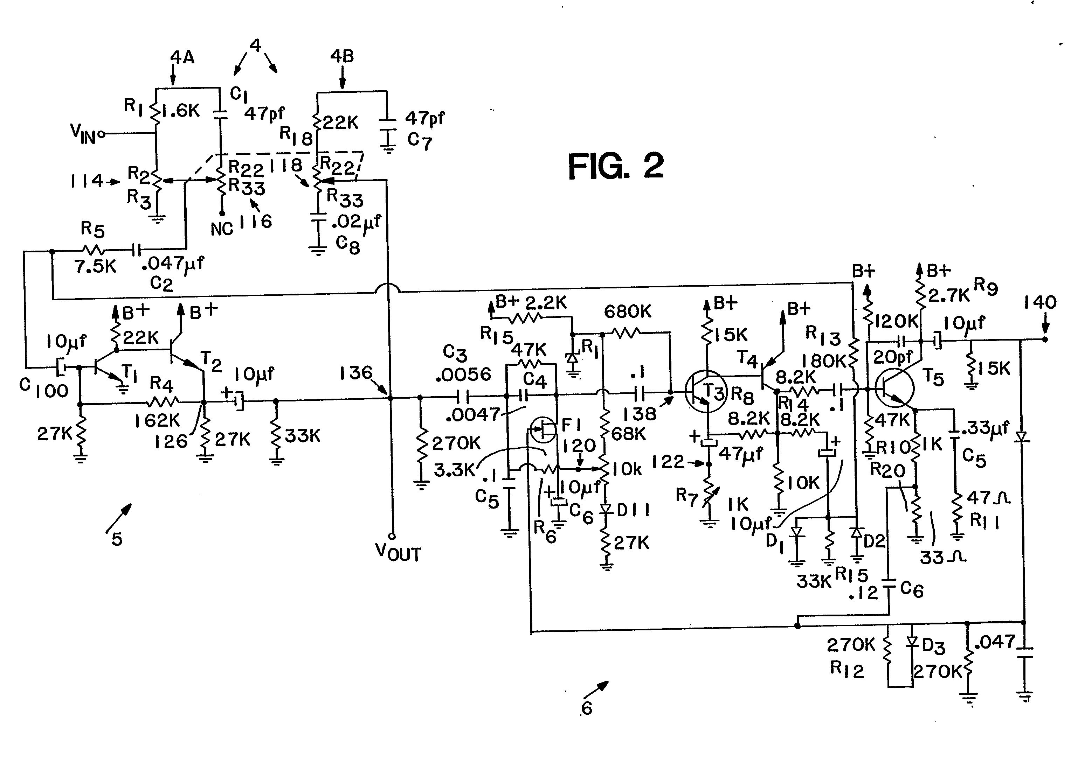

Figure 1 is a block diagram of a circuit making use of the present invention. The invention is meant for use in audio devices including but not limited to stereos, televisions, dictaphones, telephones, and VCRS. By introducing the present invention into the circuitry of an audio device, the audio sound produced by the device will be greatly enhanced.

Figure 2 discloses in detail the elements of Figure 1. The signal enters the signal conditioner (4) where it is attenuated primarily by adjustment of the first potentiometer (114) in the left-most portion of the circuit, (generally designated as (4A) and identified as a pre or input filter stage). Three potentiometers are used in signal conditioner (4), two in section (4A) the pre or input filter stage, and one in section (4B) the post or output filter stage. Each of these potentiometers are shown as valued at 100K. The first potentiometer (114) is an independent potentiometer, considered a threshold potentiometer, and could be replaced by two separate resistors here denoted R2 and R3. The second and third potentiometers (116 and 118) while electrically independent of one another, are ganged together such that an adjustment of potentiometer (116) results in an adjustment of potentiometer (118). These potentiometers could also be replaced by set value resistors and mutual adjustability, if dual potentiometers are used, is not mandatory but desirable. Of course adjustment of (114) would affect the desired resistance values of (116) and (118).

(R1) a 1.6 kilo ohm resistor is hooked in series with (C1) a 47 pico farad capacitor which is connected to ground. (R22) and (R2), the resistances, if any, from potentiometers (114) and (116) are in series with (R1) and (C1). This section of (4A) is then in parallel with the remaining resistances, if any, in potentiometers (114) and (116). Connected in parallel to the foregoing is (C2) a .047 micro farad capacitor and a 7.5 kilo ohm resistor (R5). A review of Figure 3 will assist the reader in understanding the foregoing with "Y" being the remaining resistance from potentiometer (114) and "X" being the remaining resistance from potentiometer (116).

The signal coming from input section (4A) of the signal conditioner passes through buffer (5). This buffer is similar to a TLO 82 by Texas Instruments or LM 1458 by National Semiconductor. A LM 833 by National Semiconductor could also be used. Before entering the buffer (5), the signal passes through the .047 microfarad capacitor (C2) connected in series with the 7.5 kilo ohm resistor (R5). It is then attenuated about 6db by the clipped signal from limiter 6 (discussed later) and specifically from diodes (D1) and (D2). This signal is then passed to buffer (5) by coupling capacitor (C100) of 10 microfarads value at the base of NPN amplifier (T1) to drive amplifier (T2). Since the signal on the collector of amplifier (T1) is always within range of that of the power supply, the base of amplifier (T2) will be between the power supply and ground. Therefore amplifier (T2) is in the active region with its base-emitter diode in conduction to add to the signal at node (126). Amplified in this fashion the signal leaves buffer (5) through node (136) to see (4B) of the signal conditioner, the post filter, as well as limiter (6).

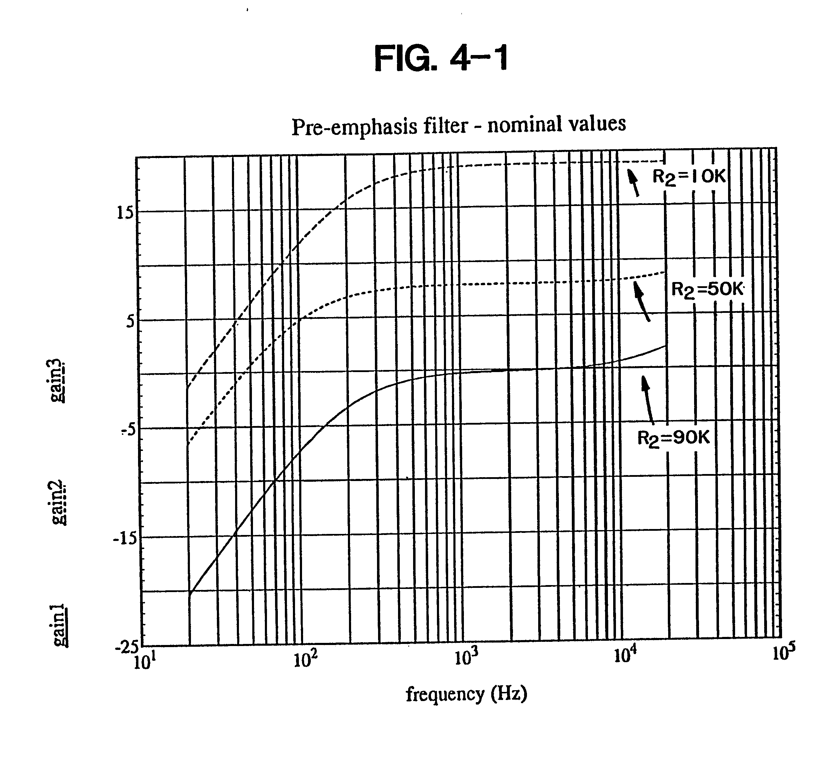

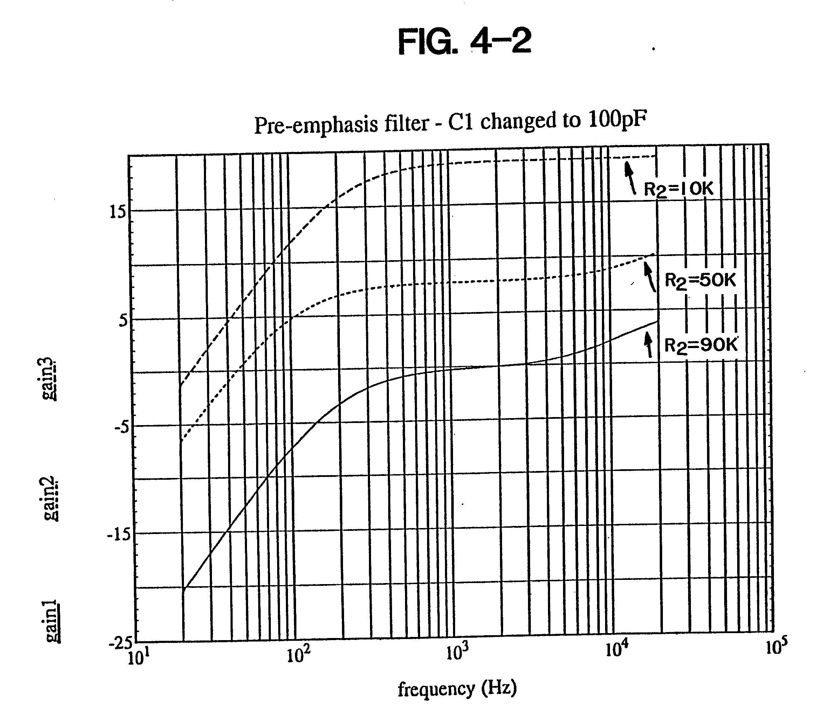

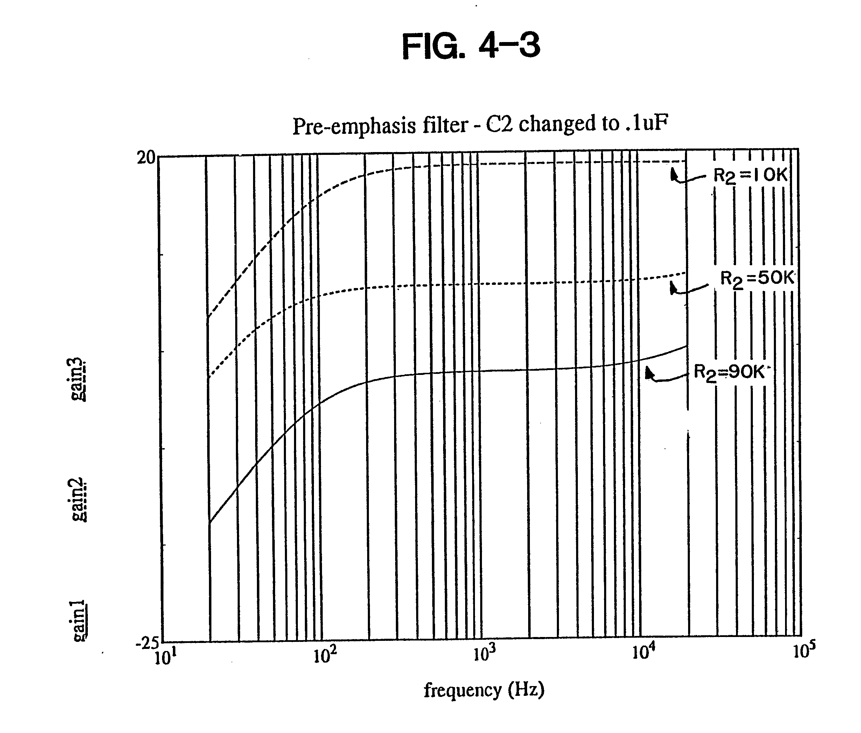

Attention is now directed to Figure 4. Here a test circuit is shown comprised of pre filter (4A) of the signal conditioner (4) and an equivalent circuit representing buffer (5). To isolate the response of these elements, gain was calculated. Figures 4-1, 4-2 and 4-3 graph the results. Gain 1 represents (R2) at a value of 10 kilo ohms; gain 2 represents (R2) at a value of 50 kilo ohms; and gain 3 represents (R2) at a value of 90 kilo ohms. In figure 4-1, other than (R2), all values are as shown in figure 4. In figure 4-1 it is notable that after a certain frequency there is no increase in gain. It .was found that R1 had essentially no effect on the signal until R2 was made very small. Then R1 acted to keep the high frequency gain from going too high.

In figure 4-2 (C1) was increased to isolate its effect on the circuit. Here it was found that by this increase, at higher frequencies the gain was increased slightly.

In figure 4-3 (C2)'s value was increased. This increase reduced the low corner frequency.

An increase in (R4) moved up the response but had no effect on the shape of the curve. An increase in (R5) decreased the mid-band gain but did not effect lower frequencies. ·

Analyzing mathematically the gain of only (4A), (that is assuming V out is at point (122) and precedes buffer (5) ), the poles were found to be very positive, the gain being constant over a broad range of frequencies. These computations are in line with the graphs in figures 4-1 through 4-2. Thus the circuitry of (4A), yields a very flat response through the audio range, its amplitude being attenuated by the adjustment of potentiometer (114).

After passing through buffer (5) with the above discussed results, the signal sees limiter (6) as well as post filter (4B).

Limiter (6) takes its basis from Figures 6 and 8 of United States Patent RE 28426 but differs in several significant respects some of which are mentioned below and others of which will be readily evident when comparing the circuit of the present invention with those in the noted patent. In the present invention, limiter 6 is connected at its input to ground through .1 microfarad capacitor (C5). It is believed that this capacitor operates in conjunction with gain elements in the limiter to attenuate the signal about 6 db (that is to cut the signal in half). This would assist cascading a plurality of circuits of the present invention together for specific circuit design. What signal remains then enters the circuitry surrounding FET (F1) and the 3.3 kilo ohm resistor (R6) (the arrangement of which was taken from Figure 8 of the above-noted patent). As described in that patent, when the FET (F1) is off, the RC network defined by the 47 kilo ohm resistor (R15) and the .0047 pico farad capacitor (C4) is inoperative and all of the signal passes through the RC network defined by the 3.3 kilo ohm resistor (R6) and the .10 micro farad capacitor (C6). This circuitry then combines the phase advantages of having only one RC network filtering the signal at quiescent conditions while achieving a 12 db per octave attenuation under signal conditions. Figure 5 isolates this portion of the circuit which may be considered the signal conditioning sliding high pass filter section. Figures 5-1 through 5-7 show test outputs resulting from this circuitry. Gain 1 was found with R FET at 100 kilo ohms; gain 2 was found with R FET at 10 kilo ohms; gain 3 was found with R FET at 1 kilo ohm; and gain 4 was found with R FET off. In figure 5, R FET represents (F1) and is a variable resistance whose value is determined by the location of potentiometer (120) in figure 2 and on the gate voltage. The higher the gate voltage the lower the resistance and thus the higher the corner frequency. (C6) sends a small signal to ground but has no effect on the frequency response.

In figure 5-1, the frequency response for the four different values of R FET are shown, the remaining components being unchanged. As noted above, with R FET at a high value or off the corner frequency is lower.

Figure 5-2 shows the result of increasing (C3). The gain is raised at all frequencies but the shape left unchanged.

In figure 5-3, (C4) is increased and results in a slight gain increase for lower values of R FET.

In figure 5-4, (C5) is increased which expectedly decreases the high frequency gain and the corner frequency.

Figure 5-5 shows the response with (C5) removed altogether. No graph is shown for R FET being off. Here gain is higher at high frequencies and the corner frequency is at a higher frequency.

Figure 5-6 shows that a decrease in the value of R15 results in a slight increase in low frequency gain.

Figure 5-7 shows a decrease of R6 results in a decrease of low frequency gain.

The original Dolby response disclosed in the above-noted patent, is shown for comparison in Figure 5.9. In Dolby, the corner frequency is higher as is the high frequency gain. This difference is in part attributable in the present circuit to (C5).

The signal leaving this high pass filter section passes to NPN, PNP amplifiers (T3) (T4) respectively, by means of potentiometer (120) which as shown in the cited patent and here lies in a voltage divider line and includes a temperature compensating germanium diode (D11). In parallel with the voltage divider line just referred to is an 8.2 volt zener diode (Z1) which ensures that the reference voltage at the base of amplifier (T3) does not exceed 8.2 volts.

Amplifiers (T3, T4) like those in Figure 6 of the U.S. Patent referred to herein, are complementary to yield a high input impedance and a low output impedance. The diodes (D1, D2) are silicon having knees at about 1/2 volt. Amplifier (T4) drives the diode limiters (D1, D2) whose signal attenuates the output from (4A) (not disclosed in the noted patent) and thus the signal entering buffer (5). Reference is made to figure 6 for a closer review of the circuitry now discussed. This section may be referred to as the buffer/limiter. The gain from V3 to V2 is

$$\frac{-162K}{180K} \left( 1 + \frac{8.2K}{R7} \right)$$

Diodes (D1, D2) limit the signal going into buffer (5).

Increasing (R8) and/or decreasing (R7) increases the gain at this stage. This will then increase the signal going into (D1) and (D2). Thus the limiting will be the same.

Decreasing (R13) will also increase gain but not the signal that (D1) and (D2) see. Thus the limiting will be less sensitive. It is believed that (R13) should not be reduced below 100K.

Moving through V4 to figure 7 and as shown in figure 2, amplifier (T5) is driven by amplifier (T4) and like the cited patent, is an NPN transistor with an emitter time constant network giving increased gain at high frequencies. Thus the crash of a cymbal will lead to rapid narrowing of the band in which compression takes place to avoid signal distortion. Amplifier (T5) has a fairly low impedance from measures at the collector of (T4) and therefore, the mathematical effect of (R30) of 8.2 kilo ohms and (C30) of .1 micro farad are not so significant.

In figure 7, which isolates the final section of the limiter (6) of the circuit of figure 2, the voltage at node 140 will be, for low frequencies the voltage at node 138 multiplied by $\frac{R9}{R10}$.

For frequencies higher than about 10KHZ, the gain will change to V4 multiplied by $\frac{R9}{R11}$.

The gate voltage (Vg) of (F1) clearly then responds more to high frequencies. For this reason, this section might be referred to as the peak detector. The critical frequency can be changed by adjusting (C5) and/or (R11). The voltage at the gate of (F1) will be about 1 volt below the peak voltage at node 140. This peak voltage will decay after about 30 ms. The time constant being determined by (R12) and (C6). In figure 6, the 33 ohm resistor (R20) is mathematically not significant. However in terms of sound it seems to be wise to include it for better acoustic effects.

Now the second stage (4B), of the signal conditioner must be considered.

The second stage of the signal conditioning unit designated generally by (4B) and referred to as the post or output filter stage affects the system at the final output stage, after it has passed through buffer (5) and been processed by limiter (6). This portion of the signal conditioning unit renders a gain approximating one. If potentiometer (118) is turned fully counterclockwise, high frequencies will pass through capacitor (C8) in (4B) which is the .02 micro farad capacitor to ground. At low frequencies, the gain will be high until about 3.7 kilohertz when the first pole is crossed. On the other hand, when potentiometer (118) is turned fully clockwise, the high gain will be much more constant. The output circuit (4B) has a close to unity gain at very low frequencies with additional attenuation through the audio band. This is especially noticeable when the potentiometer (118) is turned counterclockwise.

In figure 8 portion (4B) is isolated for better study. Figures 8-1 and 8-2 show test results made with respect to this circuit. Gain 1 shows (R22) with a value of 10 kilo ohms; gain 2 shows (R22) with a value of 50 kilo ohms; and gain 3 shows (R22) with a value of 90 kilo ohms. From these figures it appears that the effect of (4B) on the output is small. Amp 1 in figure 8 circuitry represents buffer (5) as amp 1 with an output resistance (RO) modeled as 600 ohms. There is a strong dependence of the circuit on this output resistance. (C3) (.0056 micro farads) in the limiter (6) also loads the output especially at high frequencies. Figure 8-2 shows the frequency response with a .0056 micro farad capacitor from output to ground added. While portion (4B) seems mathematically to have little effect on the sound and could theoretically be omitted, it is believed that it has a psycho acoustic effect. Therefore, it should likely not be so lightly dismissed.

A modified version of this invention is shown in figures 9 and 9-1. Here integrated circuits have been used to replace other analog components in the buffer (5) and limiter (6). Also AC and DC ground connections are introduced and some resistors and capacitors deleted. Their deletion has been made based upon mathematical calculation. However some of these deleted elements again seem to have psycho acoustic effects on the sound produced and therefore should be tested in any circuit built. Elements not shown are those making up section 4B and (R20) in the limiter (6). Figure 9-1 shows the AC/DC ground connections.

In the foregoing description the limiter (6) was analyzed by breaking it into three segments. In figure 10 a second flow chart captivating that analysis is set forth. As stated earlier herein, this invention makes use of the noise suppression characteristics of a Dolby-type expander with carefully tuned pre and post filters. The result is a flat frequency response with substantial noise reduction without use of a compressor and without any decoding required. Figure 10 identifies clearly the differing aspects of limiter (6). The first section is the sliding high pass filter plus buffer system (Figures 5 through 5-8). The second section is the buffer/limiter (Figure 6) and the third is the peak detector (Figure 7). If the signal conditioning unit 4A, 4B is ignored, the transfer function of the limiter (6) with buffer (5) is V2/V1 and is given by

$$\frac{1}{1+H(jw)} ,$$

where H(jw) is the sliding high pass filter plus buffer characteristics.

$$H(jw) = \frac{A \frac{jw}{wc}}{1 + \frac{jw}{wc}} ,$$

wc is the corner frequency and A is the high frequency gain.
Thus

$$V2/V1 = \frac{1 + \frac{jw}{wc}}{1 + \frac{jw}{wc}(1 + A)} .$$

Figure 11 discloses the frequency amplitudes taking into account the foregoing. The corner frequency (fc) is that of the sliding high pass filter. Corner frequency control is indicated by numeral (14) in figure 10. "A" is a function of the high frequency gain of the high pass filter and buffer. A typical value for $\frac{1}{1 + A}$ is about 0.5 or -6 db. (15) is the lower amplitude chart, (16) the higher amplitude chart, both making use of the formula $\frac{1}{1 + A}$.

The frequency response found in the sliding high pass filter (figure 5) multiplied by the flat gain of the buffer, limiter stage (figure 6) yields the H(jw) discussed above. The gain from V3 to V2 discussed with respect to figure 6 is multiplied by the high frequency gain of the signal conditioner (-25db = a gain of .056) to give the value of "A".

In conclusion, the present invention combines a simple, tunable circuit with a Dolby-type expander to provide an efficient yet simple noise reduction system. Some of this combination may be analyzed mathematically. It is believed that those portions which do not justify themselves mathematically may do so practically, a psycho-acoustic effect being possibly created thereby.

Accordingly, applicant claims this invention as follows.

## Claims

1. A circuit for sound improvement having a Vin and a Vout as well as power and ground connection, said circuit being used in combination with a Dolby-type expander limiter and being comprised of:
a prefilter connected at one end to Vin;
a buffer having in input and an output said input being connected to said prefilter;
said Dolby-type expander limiter having an input and an output, the output of said buffer being connected to the input of said limiter as well as to Vout, the output of said limiter being connected between said prefilter and said buffer, said circuit acting in conjunction with said limiter to improve sound signals fed therethrough.

2. The circuit of claim 1 further comprising a post filter connected between the output of said buffer and the input of said limiter and Vout.

3. The circuit of claim 1 wherein said prefilter is comprised of a first and a second portion, said first portion being connected in parallel with said second portion at one end and to Vin at the other end, said first portion being comprised of a first resistance connected in series with a capacitance, the two being connected in parallel with a second resistance, said second portion being comprised of at least one resistance connected at one end to ground,

4. The circuit of claim 3 wherein said prefilter is comprised of a third portion connected in parallel with said first and said second portion and said limiter and said third portion being comprised of a resistor connected in series with a capacitor.

5. The circuit of claim 3 wherein said first resistance in said first portion is comprised of a set resistance and an adjustable resistance.

6. The circuit of claim 4 wherein said first resistance in said first portion is comprised of a set resistance and an adjustable resistance.

7. The circuit of claim 4 wherein the value of said second resistance is dependent upon the value of said resistance in said second portion of said prefilter.

8. The circuit of claim 6 wherein the value of said second resistance is dependent upon the value of said resistance in said second portion of said prefilter.

9. The circuit of claim 8 further comprising a post filter connected between the output of said buffer, the input of said limiter, and Vout, said post filter being comprised of a resistor, said resistor having a value dependent upon said first resistor in said first portion of said prefilter.

10. The circuit of claim 9 wherein the resistor in said post filter is at least close in value to that of said first resistor in said first portion of said prefilter.

11. The circuit of claim 10 wherein said first resistor in said first portion of said prefilter and said resistor in said postfilter are ganged together potentiometers.

6

EP 0 356 885 A2

FIG. 1

$V_{IN}$

4A

SIGNAL CONDITIONER PRE-FILTER

5
BUFFER

6
LIMITER

4B

SIGNAL CONDITIONER POST FILTER

$V_{OUT}$

FIG. 3

$V_{IN}$

R1+R2
$(1.6+100(1-X))K$

$C_1$ 47pf

$(100(1-y))K$
$R_{22}$

$R_3$ 100yK

$R_5$ 7.5K

$C_2$ .047μf

FIG. 4

4A

$V_{IN}$

$R_1$ 1.6K

47pf $C_1$

$R_2$

114 → $R_3$

$R_{22}$ 100K

H6

100K

.047μf $C_2$

122

7.5K $R_5$

$R_4$ 162K

Amp.

$V_{OUT}$

5

**FIG. 2**

EP 0 356 885 A2

# FIG. 4-1

Pre-emphasis filter - nominal values

EP 0 356 885 A2

# FIG. 4-2

Pre-emphasis filter - C1 changed to 100pF

EP 0 356 885 A2

# FIG. 4-3

Pre-emphasis filter - C2 changed to .1uF

EP 0 356 885 A2

FIG. 5

FIG. 7

EP 0 356 885 A2

# FIG. 5-1

## Signal Conditioning - nominal values

EP 0 356 885 A2

# FIG. 5-2

Signal Conditioning - C3 changed to .01uF

EP 0 356 885 A2

# FIG. 5-3

## Signal Conditioning - C4 changed to .01uF

EP 0 356 885 A2

# FIG. 5-4

**Signal Conditioning - C5 changed to .15uF**

# FIG. 5-5

Signal Conditioning Stage - C5 removed

EP 0 356 885 A2

# FIG. 5-6

Signal Conditioning–R15 changed to 33k

EP 0 356 885 A2

# FIG. 5-7

## Signal Conditioning - R6 changed to 1.5k

EP 0 356 885 A2

# FIG. 5-8

## Original Dolby Sliding Filter

EP 0 356 885 A2

# FIG. 6

# FIG. 11

EP 0 356 885 A2

FIG. 10

FIG. 8

EP 0 356 885 A2

# FIG. 8-1

**Enhance Filter - nominal values**

EP 0 356 885 A2

# FIG. 8-2

## Enhance Filter - .0056uF load added

EP 0 356 885 A2

# FIG. 9

EP 0 356 885 A2